# EUROPEAN PATENT APPLICATION

(11) **EP 4 716 432 A1**
(43) Date of publication of application: **25.03.2026**
(21) Application number: 24201438.9
(22) Date of filing: 19.09.2024
(51) Int. Cl.: H10K 30/85, H10K 71/13, H10K 71/15, H10K 85/50, H10K 30/86, C09D 11/033, B41J 2/01

(54) **PEROVSKITE SOLAR CELL PRODUCTION AND RELATED USE, PRODUCTS AND SOLAR CELL**

(71) Applicant: TOYOTA JIDOSHA KABUSHIKI KAISHA, Aichi-ken, 471-8571 (JP)
(72) Inventor: KINGE, Sachin, 1140 BRUSSELS (BE); VITANOV LUCIE, Castens, 1720 CORMINBOEUF (CH); GUGLER, Gilbert, 1723 MARLY (CH); KESSLER, Philip, 1700 FRIBOURG (CH); NAZEERUDDIN, Mohammad Khaja, 1015 LAUSANNE (CH); XIAOXIN, Gao, 1006 LAUSANNE (CH); DYSON, Paul Joseph, 1015 LAUSANNE (CH)
(74) Representative: Cabinet Beau de Loménie

(57) **Abstract**

The invention provides a use of a solution as an ink to provide, in an ink-printing operation onto a surface of an intermediate product in the production of a perovskite solar cell, a surface film convertible into a functional layer of the perovskite solar cell via drying, wherein the ink-printing operation employs a print head (P) having at least 100 nozzles and/or deposits the ink over an area of at least 0.3 m² of the surface, the functional layer is one of an electron transport layer (3a), a perovskite layer, and a hole transport layer, and the solution contains a precursor of the functional layer in a polar solvent which contains an alcohol and/or and ether.

## Description

### BACKGROUND OF THE INVENTION

### 1. Field of the invention

The present disclosure relates to a perovskite solar cell and its production, the solar cell including a substrate a surface of which is provided with electrode wiring and further in the stated order with a stack of functional layers being, an electron transport layer on the substrate side, a perovskite layer, and a hole transport layer. The disclosure also relates to a method of producing a product which is processable into or is a perovskite solar cell, in particular the aforementioned one, as well as a printer and its print head used in this method. The disclosure also relates to a use of a solution as an ink to provide, in an ink-printing operation onto a surface of an intermediate product in the production of a perovskite solar cell, a surface film convertible into a functional layer of the perovskite solar cell via drying.

### 2. Description of Related Art

Perovskite solar cells (PSCs) formed with functional layers, namely a perovskite layer between an electrode transport layer and a hole transport layer have rapidly developed to become one of the most promising photovoltaic technologies over the last decade, achieving the power conversion efficiency (PCE) like 26%. Perovskite solar cells and known production of such cells based on organic semiconductors are described e.g. in
- Zhang et al., "Ion-modulated radical doping of spiro-OMeTAD for more efficient and stable perovskite solar cells", Science, 28 July 2022, Vol 377, Issue 6605 pp. 495-501 (DOI: 10.1126/science.abo2757), and
- You et al., 2023 - You et al., "Bifunctional hole-shuttle molecule for improved interfacial energy level alignment and defect passivation in perovskite solar cells", Nature Energy, 8, pp. 515-525, 2023 (https://doi.org/10.1038/s41560-023-01249-0).

As a base material for forming a hole transport layer of a perovskite solar cell is a polymer component, e.g. from the product PEDOT:PSS is known which combines Poly(3,4-ethylenedioxythiophene) and polystyrene sulfonate. The product is available e.g. from Xi'an Polymer Light Technology Corp. in Xi'an, China or under the trademark CLEVIOS from Heraeus Epurio GmbH, CHEMPARK Leverkusen, 51368 Leverkusen, Germany. It is supposed to provide stability of a hole transport layer in a perovskite solar cell, specifically regularly structured n-i-p type cells. Other known polymers for such a polymer component suitable as a base material for forming the hole transport layer are poly[bis(4-phenyl)(2,4,6-triMethylphenyl)amine] (PTAA) and poly(3-hexylthiophene) (P3HT). These polymer components include a conductive polymer like a thiophene-based polymer. A hole transport layer of a perovskite solar cell further includes a spiro compound as a charge transfer agent.

Solutions for forming functional layers of a PSC are shown in - D.K. Lee et al., "Precursor Engineering for a Large-Area Perovskite Solar Cell with >19% Efficiency", ACS Energy Letters 2019 4 (10), 2393-2401, and - (5) M. Yavari et al., "Greener, Nonhalogenated Solvent Systems for Highly Efficient Perovskite Solar Cells", Advanced Energy Materials, April 2018 (21):1800177.

Attempts to allow inkjet printing of a functional layer of a PSC are reported in
- F. Schackmar et al., "Perovskite Solar Cells with All-Inkjet-Printed Absorber and Charge Transport Layers", Adv. Mater. Technol. 2021, 6 (2), 2000271,
- B. Gao et al., "Flexible CH3NH3PbI3 perovskite solar cells with high stability based on all inkjet printing", Solar Energy, 230, 2021, 598-604, and
- A. Gheno et al., "Toward Highly Efficient Inkjet-Printed Perovskite Solar Cells Fully Processed Under Ambient Conditions and at Low Temperature", Solar RRL, 2018, 2 (11), pp.1800191.

Known conditionings before a functional layer deposition include cleaning, annealing, a plasma treatment, a flame treatment or a corona treatment, and vacuum-annealing and some conditionings are shown in A. B. Djurisic et al., "Surface treatments of indium tin oxide substrates: comprehensive investigation of mechanical, chemical, thermal, and plasma treatments", Proc. SPIE 4464, Organic Light-Emitting Materials and Devices V, (27 February 2002). J. Liu et al., "Effect of surfactants on the structure and photoelectric properties of ITO films by sol-gel method", Rare Metals 29, 143-148 (2010), shows a surfactant-based conditioning.

### SUMMARY

The object of the present invention is to at least substantially remedy the above-mentioned drawbacks of the prior art. The object of the present invention to allow efficiently providing solar cells, in particular of large size and in a cost-efficient manner. The object of the present invention to facilitate the production of solar cells, in particular of large size. Avoiding an excessive use toxic substances contributes to achieving the object.

In this respect, the present disclosure relates to a use of a solution as an ink to provide, in an ink-printing operation, in particular an ink-jet-printing operation, onto a, preferably conditioned plasma-treated, surface in particular of an intermediate product in the production of a perovskite solar cell, a surface film convertible into a functional layer of the perovskite solar cell via drying, wherein the ink-printing operation employs a print head having at least 100, preferably at least 200 nozzles and/or deposits the ink over an area of at least 0.3 m², more preferably at least 0.5 m² or even 1 m² of the surface, preferably one adjusted for a resolution between 100 dpi x 100 dpi and 2400 dpi x 2400 dpi and a drop size between 1 pL and 225 pL, more preferably between 3 and 20 pL, wherein the functional layer is an electron transport layer, and the solution contains a precursor of the functional layer in a polar solvent which contains an alcohol and/or and ether. The surface may be a surface of an inorganic material and plasma-treated with a surfactant, preferably a nonionic surfactant and conditioning concepts from the initially mentioned prior art on conditioning may be used for this purpose.

The solvent preferably contains an alcohol like the alcohol, preferably at least one of ethylene glycol, n-propanol, glycerol, isopropoxyethanol, and 2-amino-2-methyl-propanol, and a viscosity of the solution is preferably between 7 mPa·s and 14 mPa·s, more preferably between 9 mPa·s and 12 mPa·s. The solvent more preferably contains water, ethylene glycol and glycerol. These viscosities and viscosities described hereafter are in particular dynamic viscosities measured in accordance with ASTM D7042-2021.

The drying preferably includes subjecting the surface film to a combination of heating and near infrared irradiation.

The precursor comprises preferably dispersed tin oxide, preferably as particles with a diameter, D50 between 0.1 µm and 0.3 µm, more preferably as particles with a D50 between 0.15 µm and 0.25 µm.

The present disclosure also relates to a use of a solution as an ink to provide, in an ink-printing operation, in particular an ink-jet-printing operation, onto a surface (a surface of an electron transport layer of a perovskite solar cell, preferably conditioned plasma-treated), in particular of an intermediate product in the production of a perovskite solar cell, a surface film convertible into a functional layer of the perovskite solar cell via drying, wherein the ink-printing operation employs a print head having at least 100, preferably at least 200 nozzles and/or deposits the ink over an area of at least 0.3 m², more preferably at least 0.5 m² or even 1 m² of the surface, preferably one adjusted for a resolution between 100 dpi x 100 dpi and 2400 dpi x 2400 dpi and a drop size between 1 pL and 225 pL, more preferably between 3 and 20 pL, wherein the functional layer is an perovskite layer, and the solution contains a precursor of the functional layer in a polar solvent which contains an alcohol and/or and ether. The surface may be a surface of an inorganic material and plasma-treated with a surfactant, preferably a nonionic surfactant and conditioning concepts from the initially mentioned prior art on conditioning may be used for this purpose.

The solvent preferably contains alcohol and ether groups like, preferably 2-methoxy ethanol and/or methoxy propanol, and e.g. a viscosity of the solution is preferably between 2.5 mPa·s and 5.5 mPa·s, e.g. between 3 mPa·s and 5 mPa·s, more preferably between 3 mPa·s and 4 mPa·s. The solvent preferably does not contain water and preferably does neither contain DMF nor DMSO.

The drying preferably includes subjecting the surface film to a combination of air drying (preferably with compressed air, e.g. above 0.2 MPa directed to the surface) and annealing.

The precursor typically comprises lead salts with iodine ions and acetate ions and may be a commonly known perovskite layer precursor, e.g. from the initially mentioned prior art showing perovskite layer precursors.

The present disclosure also relates to a use of a solution as an ink to provide, in an ink-printing operation, in particular an ink-jet-printing operation, onto a surface (a surface of a perovskite layer of a perovskite solar cell, preferably conditioned plasma-treated), in particular of an intermediate product in the production of a perovskite solar cell, a surface film convertible into a functional layer of the perovskite solar cell via drying, wherein the ink-printing operation employs a print head having at least 100, preferably at least 200 nozzles and/or deposits the ink over an area of at least 0.3 m², more preferably at least 0.5 m² or even 1 m² of the surface, preferably one adjusted for a resolution between 100 dpi x 100 dpi and 2400 dpi x 2400 dpi and a drop size between 1 pL and 225 pL, more preferably between 3 and 20 pL, wherein the functional layer is a hole transport layer, and the solution contains a precursor of the functional layer in a polar solvent which contains an alcohol and/or and ether, preferably an aromatic ether, in particular anisole. A viscosity of the solution is preferably between 0.5 mPa·s and 1.0 mPa·s.

The precursor may be one of the initially mentioned prior art showing hole transport layer and preferably includes spiro-OMeTAD and/or PTAA typically comprises lead salts with iodine ions and acetate ions and may be a commonly known perovskite layer precursor, e.g. from the initially mentioned prior art showing perovskite layer precursors.

Features of above uses particularly ensure excellent wetting for high quality surface film formation with suppressed clogging potential for a print head, in particular an industrial print head.

The above substrate may be glass, ITO, FTO, TCO coated glass, PEN or a combination of two or more of these materials and preferably withstands at least temperatures of up to 120°C.

For each of the above uses a print head may be filled with the solution used, like an industrial print head or in particular a print head for ink-printing operation for depositing ink onto an area of at least 0.3 m² of the surface with a resolution between 100 dpi x 100 dpi and 2400 dpi x 2400 dpi and a drop size between 1 pL and 225 pL, the a print head having at least 100 nozzles and being filled with a solution as the ink for providing in the ink-printing operation a surface film convertible into a functional layer of the perovskite solar cell via drying,

An ink-jet printer for ink-printing operation for depositing ink onto an area of at least 0.3 m² of a surface with a resolution between 100 dpi x 100 dpi and 2400 dpi x 2400 dpi and a drop size between 1 pL and 225 pL may comprise the print head.

For each of the above uses the invention provided a method in line with the use. Thus, the present disclosure also relates to a method of producing a product which is processable into or is a perovskite solar cell including a substrate, a surface of which is provided with electrode wiring and further in the stated order with a stack of functional layers being, an electron transport layer on the substrate side, a perovskite layer, and a hole transport layer, to form the perovskite solar cell, wherein the product is produced by
depositing a surface film convertible into one of the functional layers using an in an ink-printing operation with the printer according to claim 12 for a resolution between 100 dpi x 100 dpi and 2400 dpi x 2400 dpi and a drop size between 1 pL and 225 pL, on an area of at least 0.3 m² of a surface obtained from a conditioning, and
converting the surface film into one of the functional layer which includes evaporation of the solvent deposited from the print head of the printer in said depositing.

The conditioning includes at least one operation selected from cleaning, annealing, a plasma treatment, a flame treatment or a corona treatment, and vacuum-annealing at a temperature between 90°C and 180°C for 5 to 45 minutes.

This method allows to provide a method of producing a product which is a perovskite solar cell including a substrate a surface of which is provided with electrode wiring and further in the stated order with a stack of functional layers being, an electron transport layer on the substrate side, a perovskite layer, and a hole transport layer, the method comprising - repeatedly and for forming each of the functional layers - performing the method with the conditioning as and additional operation prior to the depositing. With this method a perovskite solar cell, the solar cell including a substrate a surface of which is provided with electrode wiring and further in the stated order with a stack of functional layers being, an electron transport layer on the substrate side, a perovskite layer, and a hole transport layer, becomes obtainable, in particular of a large area and in an efficient manner.

Preferably the print head disclosed and that mentioned above in relation of the disclosed uses, methods and printer is one with more than 1000 nozzles.

Ink-printing (drop deposition) is preferably performed at the following temperature(s) of the substrate, i.e., the intermediate product onto which ink is printed:

| Purpose of ink-printing | T (°C) |
|---|---|
| for forming a surface film convertible into an electron transport layer | 80-98 |
| for forming a surface film convertible into a perovskite layer | 35-50 |
| for forming a surface film convertible into a hole transport layer | 50-60 |

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
- FIG. 1A is a schematic illustration of a formation according to the invention of a surface film convertible into an electron transport layer.
- FIG. 1B is shows ink drops deposited in the formation of a surface film convertible into an electron transport layer shown in Fig. 1A.
- FIG.2A is a schematic illustration of a formation according to the invention of a surface film convertible into a perovskite layer.
- FIG.2B is a schematic illustration of air drying in the formation according to the invention of a surface film convertible into a perovskite layer shown in Fig. 2A.
- FIG.3 is a schematic illustration of a formation according to the invention of a hole transport layer.
- FIG. 4 is shows a product from the formation of a hole transport layer shown in Fig. 3.

### DETAILED DESCRIPTION OF EMBODIMENTS

### Methods

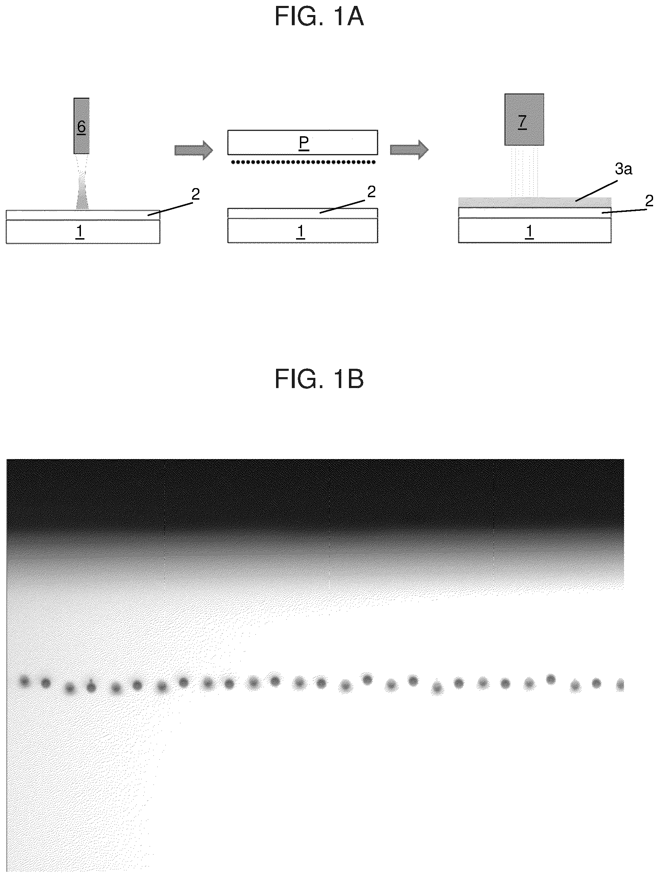

The methods illustrated in Figs. 1A, 2A and 3 may be combined as a sequence of forming functional layers 3, 4, 5. Before and after the respective ink-printing operation (depositing of drops) in the methods, conditions and materials used may be those from known perovskite solar cell productions, whereas particularly surface pretreatments and ink-printing with an industrial print head P are described in detail below.

For the method in Fig. 1A, which is performed in a cleanroom, a scribed substrate (i.e. with a wired surface having electrodes) is subjected to cleaning via immersion in a washing liquid. From left to right Fig. 1A shows subsequent operation of plasma treatment, ink-printing with a print head P to deposit drops shown as dots in Figs. 1A and 1B, and near infrared (NIR) drying.

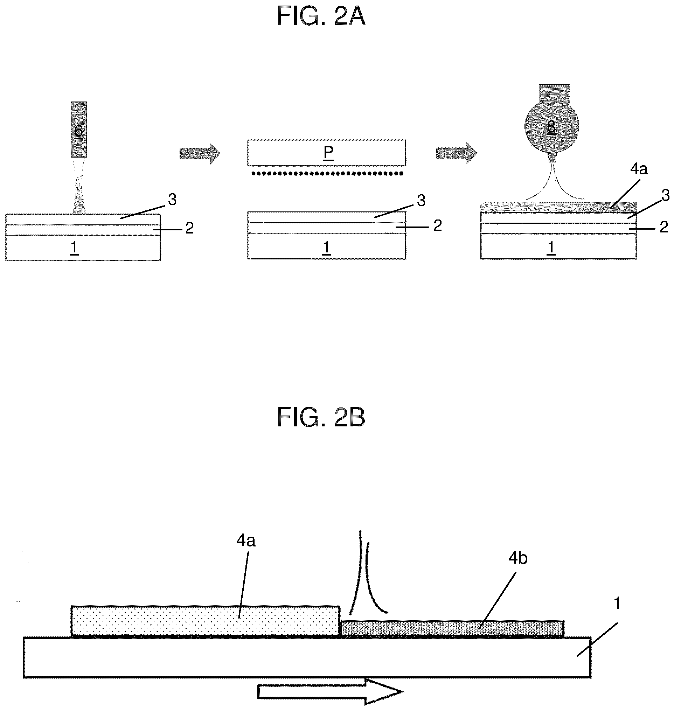

For the method in Fig. 2A the product from the method shown in Fig. 1A is subjected to ink-printing with a print head P to deposit drops shown as dots in Fig. 2A, subsequent air drying shown in Fig. 2B for solvent evaporation, thus reducing deposited surface film thickness. followed by perovskite annealing (not shown in Fig. 2A) in a cleanroom.

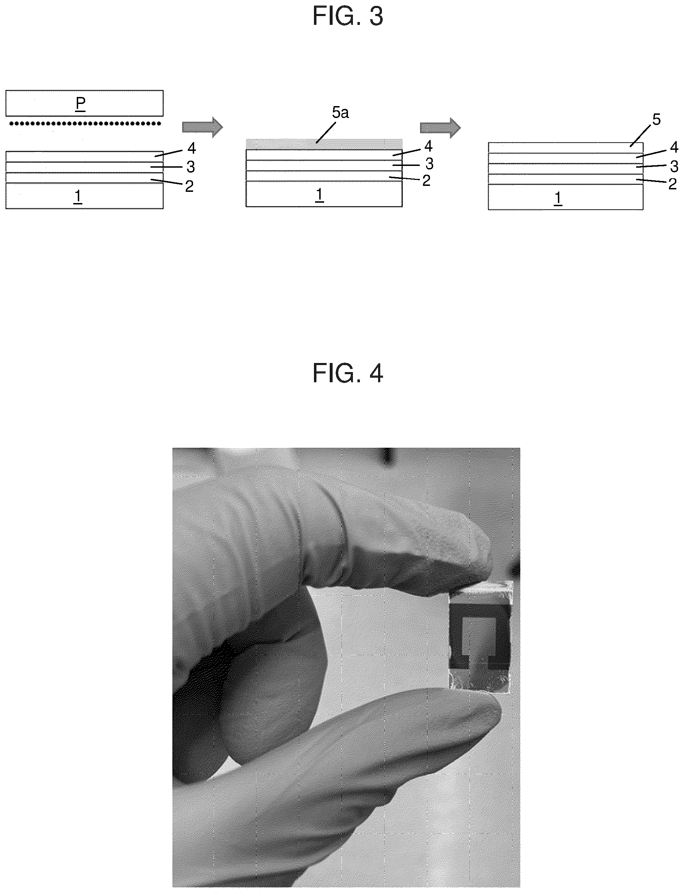

For the method in Fig. 3, which is performed in a cleanroom, the product from the perovskite annealing is subjected to ink-printing with a print head P to deposit drops shown as dots in Figs. 3, subsequent dropping off and evaporation of solvent, thus reducing deposited surface film thickness. The product from the method shown in Fig. 3 may be subjected to electrode layer deposition (vapor deposition).

### Obtained solar cell

A solar cell was produced with a sequence of these methods of Figs. 1A, 2A and 3 in line with the protocols hereafter and tested to have a high conversion efficiency PCE of 10.75% and is shown in Fig. 4.

### Electron transport layer formation

### Materials and equipment

Materials and equipment used in the layer formations described below are as follows:

| | |
|---|---|
| Material or equipment | Supplier or trademark |
| substrate | ITO PEN, Diamond Coating |
| cleaning agent | Hellmanex |
| plasma torch | inocon MicroColdPlasmaMCP501 |
| SnO₂ nanoparticles solution | Alfa Aesar |
| ethylene glycol | ROTH |
| n-propanol | TCI |
| AMP (C₄H₁₁NO) | Alfa Aesar |
| glycerol | ACROS |
| print head | ricoh MH5420, ricoh MH5421 |
| adphos NIR lamp | NIR96-250-E |
| Co[t-BuPyPz]₃[TFSI]₃ | FK209, Dyesol |
| flush solution | Siegwerk Sicura Jet flush solution |

As commercial substrate, ITO PEN from Diamond Coating was used. A P1 scribe was done on the substrate for a contact electrode. Other suitable substrates are different sorts of TCO coated glass or transparent plastic (such as FTO, ITO glass, different ITO PEN), metal coated glass or plastic. The substrate is one which can withstand temperatures of up to 120°C.

The substrate was wet cleaned: 15 min ultrasonic bath in 2% Hellmanex in deionized water, 2 times 10 min ultrasonic bath in deionized water, drying with compressed air.

Before plasma treatment, the substrate was blown with a flow of compressed air to remove particles. The substrate was plasma-treated in the cleanroom just before printing a surface film for an electron transport layer (ETL) using a plasma torch (compressed air plasma, inocon MicroColdPlasmaMCP501 plasma torch) at a distance of 5-10 mm and a x-speed of 400mm/s-800mm/s and a step of 3 mm between the lines of treatment (2 passes of plasma treatment). The plasma treatment allows, in combination with the ETL ink described below, a good wetting of the TCO. Other suitable pretreatments to achieve good wetting behavior are flame treatment, corona treatment as well as different plasma treatments.

The ETL ink was prepared using SnO₂ nanoparticles solution (15 % in H₂O, Alfa Aesar), which was mixed with ethylene glycol (ROTH), n-propanol (TCI), AMP (C₄H₁₁NO, Alfa Aesar), glycerol (ACROS) and 2-isopropoxyethanol at 9.99: 51.31: 25.65: 0.45: 4.5: 8.1 volume ratio. This ETL ink composition prevents nozzle clogging and allows good wetting of the substrate after pretreatment.

The ETL ink was filtered with a 0.2 µm particle size filter. A viscosity of the ink was 10.5 mPa·s. The ETL ink was printed in the cleanroom on a heated substrate with a ricoh MH5421 print head at a resolution of 600 dpi x 600 dpi with drops of an average volume of 10.3 pL.

The print speed was 50 mm/s and the printing distance 2-3 mm. The substrate temperature was 90°C. 15.45 s after printing (heating of the lamp), the printed ETL substrates passed 5 times under an adphos NIR lamp (NIR96-250-E (752928) nominal input Power 30W/cm) at an intensity of 30% a speed of 140 mm/s and a distance of 55 mm between the lamp and the substrate. The obtained product was plasma-treated in the cleanroom.

### Perovskite layer formation

The substrate-supported ETL from the cleanroom described above was treated with a plasma torch (compressed air plasma, inocon) at a distance of 8 mm and a x-speed of 600 mm/s and a step of 3 mm between the lines of treatment (1 pass of plasma treatment).

Before plasma treatment, the substrate was blown with a flow of compressed air to remove particles.

The perovskite precursor ink was prepared by dissolving PbI₂ (0.6 M, TCI), PbAc₂ (0.4 M, TCI) and MAI (1.8 M, Dyesol) in a 2-methoxyethanol (2-ME) solvent. The powder was mixed with the solvent around 1h before printing. It was stirred at 50°C for 20 minutes and then let to cool down while stirring for 40 minutes.

The perovskite ink composition allows a good quality perovskite while not attacking the industrial print head.

The perovskite ink was filtered with a 0.2 µm particle size filter. A viscosity of the ink was 3 mPa·s. The perovskite ink was printed on a heated substrate with a ricoh MH5420 print head at a resolution of 450 dpi x 600 dpi with drops of a volume of 18 pL. The relative humidity was decreased to 5% by introducing dry air into the platform before printing and then slowly increased. The print speed was 50 mm/s and the printing distance 2-3 mm. The substrate temperature was 40°C. 8.3 s after printing, the perovskite ink was dried with a flow of dry air (air dryer pressure 10 mm water colon) at a speed of 10 mm/s the distance between substrate and air dryer was of 5.7 mm and the slot width of the air dryer was 1mm. The surface film was then annealed at 120°C for 20 minutes in a vacuum oven at a pressure of 400 mm Hg.

For storing, the obtained product was kept in a plastic box that was vacuum sealed in a plastic bag containing silica beads.

### Hole transport layer formation

The spiro-OMeTAD/PTAA/P3HT (1.5 g) ink for a hole transport layer (HTL) was prepared by dissolving in anisole (50 mL) with 4-tert-butylpyridine (525 µL), Li-TFSI (325 µL) in acetonitrile 520 mg/mL, and Co [t-BuPyPz]3[TFSI]3 (FK209, Dyesol) (350 µL) in acetonitrile 380 mg/mL. This recipe allows to print a functional HTL without clogging or attacking the print head.

The HTL ink was filtered with a 0.2 µm particle size filter. A viscosity of the ink is 0.7 mPa·s. The HTL ink was printed on a heated product from the above-described perovskite layer formation with a ricoh MH5420 print head at a resolution of 600 dpi x 600 dpi with drops of a volume of approximately 10 pL and left until the surface was dry. The print speed was 50 mm/s and the printing distance 2-3 mm. The substrate temperature was 60°C.

For transporting, the obtained product (PSC) was stored in a plastic box and vacuum-sealed in a plastic bag containing silica beads.

### Counter electrode formation

Finally, with a thickness of 70 nm, a gold electrode was placed on the hole transport layer formed as described above via thermal evaporation as a counter electrode to complete the device fabrication.

### Preparation of the print heads

In each respective one of the above-described formations of an ETL, a perovskite layer and an HTL, the ricoh MH5420/MH5421 print head was adapted respectively as follows.

ETL print head: When unused, it was filled and capped with Siegwerk Sicura Jet flush solution. To fill in the ETL ink, in a first step the Siegwerk flush was purged and isopropanol was filled in the empty print head, in a second step the Isopropanol was purged and ethylene glycol was filled in the empty print head, finally in the third step the ethylene glycol was purged and the ETL ink was filled in. After printing, the ETL print head was cleaned as follows: In a first step the ETL ink was purged and the print head was filled with ethylene glycol, in a second step the ethylene glycol was purged and the print head was filled in with isopropanol finally in a third step the isopropanol was purged and the print head was filled and capped with Siegwerk flush solution for "storing".

Perovskite layer print head: When unused, it was filled and capped with Siegwerk flush solution. To fill in the perovskite ink, in a first step the Siegwerk flush was purged and isopropanol was filled in the empty print head, in a second step the isopropanol was purged and 2-methoxyethanol was filled in the empty print head, finally in the third step the 2-methoxyethanol was purged and the perovskite ink was filled in. After printing, the perovskite print head was cleaned as follows: In a first step the perovskite ink was purged and the print head was filled with 2-methoxyethanol, in a second step the 2-methoxyethanol was purged and the print head was filled in with isopropanol finally in a third step the isopropanol was purged and the print head was filled and capped with Siegwerk flush solution for "storing".

HTL print head: When unused, it was filled and capped with Siegwerk flush solution. To fill in the HTL ink, in a first step the Siegwerk-flush was purged and isopropanol was filled in the empty print head, in a second step the isopropanol was purged and anisole was filled in the empty print head, finally in the third step the anisole was purged and the HTL ink was filled in. After printing, the HTL print head was cleaned as follows: In a first step the HTL ink was purged and the print head was filled with anisole, in a second step the anisole was purged and the print head was filled in with isopropanol finally in a third step the isopropanol was purged and the print head was filled and capped with Siegwerk flush solution for "storing".

### Alternative perovskite precursor ink

In an alternative to the above-described specific perovskite layer formation, the perovskite precursor ink preparation is replaced by the following: Dissolving PbI₂ (0.4 M, TCI), PbAc₂ (0.4 M, TCI) and MAI (0.4 M, Dyesol) in a (2-ME) solvent. The powder was mixed with the solvent around 1h before printing. It was stirred at 50°C for 20 minutes and then let to cool down while stirring for 40 minutes.

Although the present disclosure refers to specific exemplary embodiments, modifications may be provided to these examples without departing from the general scope of the invention as defined by the claims. In particular, individual characteristics of the different illustrated/mentioned embodiments may be combined in additional embodiments. Therefore, the description and the drawings should be considered in an illustrative rather than in a restrictive sense.

### Reference signs

- 1: substrate
- 2: contact layer (wiring)
- 3: electron transport layer
- 4: perovskite layer
- 5: hole transport layer
- 3a, 4a, 5a: surface films
- 4b: dried surface film
- 6: plasma torch
- 7: near infrared (NIR) dryer
- 8: compressed air dryer
- P: print head

## Claims

1. A use of a solution as an ink to provide, in an ink-printing operation onto a surface of an intermediate product in the production of a perovskite solar cell, a surface film convertible into a functional layer of the perovskite solar cell via drying, wherein
the ink-printing operation employs a print head having at least 100 nozzles and/or deposits the ink over an area of at least 0.3 m² of the surface,
the functional layer is one of an electron transport layer, a perovskite layer, and a hole transport layer, and
the solution contains a precursor of the functional layer in a polar solvent which contains an alcohol and/or and ether.

2. The use according to claim 1, wherein
the functional layer is an electron transport layer or a perovskite layer and
the surface is a plasma-treated surface.

3. The use according to claim 2, wherein
the surface is a surface of an inorganic material and plasma-treated with a surfactant.

4. The use according to claim 2 or 3, wherein
the functional layer is an electron transport layer,
the solvent contains an alcohol and
a viscosity of the solution is between 7 mPa·s and 14 mPa·s.

5. The use according to claim 4, wherein
the drying includes subjecting the surface film to a combination of heating and near infrared irradiation.

6. The use according to claim 4 or 5, wherein
the alcohol is at least one of ethylene glycol, n-propanol, glycerol, isopropoxyethanol, and 2-amino-2-methyl-propanol, and
the precursor comprises dispersed tin oxide.

7. The use according to claim 1, wherein
the functional layer is a hole transport layer,
the solvent contains an ether and
a viscosity of the solution is between 0.5 mPa·s and 1.0 mPa·s.

8. The use according to claim 1, 2, or 3, wherein
the surface is a surface of an electron transport layer of the perovskite solar cell,
the functional layer is a perovskite layer,
the precursor comprises lead salts with iodine ions and acetate ions,
the solvent contains an ether, and
a viscosity of the solution is between 2.5 mPa·s and 5.5 mPa·s.

9. The use according to any of the preceding claims, wherein
the print head has at least 200 nozzles and/or the area is at least 0.5 m² of the surface.

10. The use according to any of the preceding claims, wherein
the ink-printing operation is one adjusted for a resolution between 100 dpi x 100 dpi and 2400 dpi x 2400 dpi and a drop size between 1 pL and 225 pL,

11. A print head for ink-printing operation for depositing ink onto an area of at least 0.3 m² of the surface with a resolution between 100 dpi x 100 dpi and 2400 dpi x 2400 dpi and a drop size between 1 pL and 225 pL, the a print head having at least 100 nozzles and being filled with a solution as the ink for providing in the ink-printing operation a surface film convertible into a functional layer of the perovskite solar cell via drying, wherein
the functional layer is one of an electron transport layer, a perovskite layer, and a hole transport layer, and
the solution contains a precursor of the layer in a polar solvent which contains an alcohol and/or and ether.

12. An inkjet printer for ink-printing operation for depositing ink onto an area of at least 0.3 m² of a surface with a resolution between 100 dpi x 100 dpi and 2400 dpi x 2400 dpi and a drop size between 1 pL and 225 pL employs, comprising the print head of claim 11.

13. A method of producing a product which is processable into or is a perovskite solar cell including a substrate, a surface of which is provided with electrode wiring and further in the stated order with a stack of functional layers being, an electron transport layer on the substrate side, a perovskite layer, and a hole transport layer, to form the perovskite solar cell
wherein the product is produced by
depositing a surface film convertible into one of the functional layers using an in an ink-printing operation with the printer according to claim 12 for a resolution between 100 dpi x 100 dpi and 2400 dpi x 2400 dpi and a drop size between 1 pL and 225 pL, on an area of at least 0.3 m² of a surface obtained from a conditioning, and
converting the surface film into one of the functional layer which includes evaporation of the solvent deposited from the print head of the printer in said depositing,
wherein the conditioning includes at least one operation selected from cleaning, annealing, a plasma treatment, a flame treatment or a corona treatment, and vacuum-annealing at a temperature between 90°C and 180°C for 5 to 45 minutes..

14. A method of producing a product which is a perovskite solar cell including a substrate a surface of which is provided with electrode wiring and further in the stated order with a stack of functional layers being, an electron transport layer on the substrate side, a perovskite layer, and a hole transport layer, the method comprising - repeatedly and for forming each of the functional layers - performing the method of claim 13 with the conditioning as and additional operation prior to the depositing.

15. A perovskite solar cell, the solar cell including a substrate a surface of which is provided with electrode wiring and further in the stated order with a stack of functional layers being, an electron transport layer on the substrate side, a perovskite layer, and a hole transport layer, wherein the perovskite solar cell is obtainable according to the method of claim 14 and has a surface area of at least 0.3 m².

## Amended claims

### Amended claims in accordance with Rule 137(2) EPC.

1. A use of a solution as an ink to provide, in an ink-printing operation onto a surface of an electron transport layer of an intermediate product in the production of a perovskite solar cell, a surface film convertible into a functional layer of the perovskite solar cell via drying, wherein
the ink-printing operation employs a print head having at least 100 nozzles and/or deposits the ink over an area of at least 0.3 m² of the surface,
the functional layer is a perovskite layer, and
the solution contains a precursor of the functional layer in a polar solvent, wherein the precursor comprises lead salts with iodine ions and acetate ions,
**characterized in that**
the solvent contains an ether, and
a viscosity of the solution is between 2.5 mPa·s and 5.5 mPa·s.

2. The use according to claim 1, wherein
the surface is a plasma-treated surface.

3. The use according to claim 2, wherein
the surface is a surface of an inorganic material and plasma-treated with a surfactant.

4. The use according to any of the preceding claims, wherein
the print head has at least 200 nozzles and/or the area is at least 0.5 m² of the surface.

5. The use according to any of the preceding claims, wherein
the ink-printing operation is one adjusted for a resolution between 100 dpi x 100 dpi and 2400 dpi x 2400 dpi and a drop size between 1 pL and 225 pL,

6. A print head for ink-printing operation for depositing ink onto an area of at least 0.3 m² of the surface with a resolution between 100 dpi x 100 dpi and 2400 dpi x 2400 dpi and a drop size between 1 pL and 225 pL, the print head having at least 100 nozzles and being filled with a solution as the ink for providing in the ink-printing operation a surface film convertible into a functional layer of the perovskite solar cell via drying and on a surface of an electron transport layer of the perovskite solar cell, wherein
the functional layer is a perovskite layer, and
the solution contains a precursor of the layer in a polar solvent which contains an alcohol and/or and ether, wherein the precursor comprises lead salts with iodine ions and acetate ions,
**characterized in that**
the solvent contains an ether, and
a viscosity of the solution is between 2.5 mPa·s and 5.5 mPa·s.

7. An ink-jet printer for ink-printing operation for depositing ink onto an area of at least 0.3 m² of a surface with a resolution between 100 dpi x 100 dpi and 2400 dpi x 2400 dpi and a drop size between 1 pL and 225 pL employs, comprising the print head of claim 6.

8. A method of producing a product which is processable into a perovskite solar cell including a substrate, a surface of which is provided with electrode wiring and further in the stated order with a stack of functional layers being an electron transport layer on the substrate side, and a perovskite layer to form the perovskite solar cell,
wherein the product is produced by
depositing a surface film convertible into the perovskite layer using a solution containing a precursor of the perovskite layer in a polar solvent in an ink-printing operation with the printer according to claim 12 for a resolution between 100 dpi x 100 dpi and 2400 dpi x 2400 dpi and a drop size between 1 pL and 225 pL, on an area of at least 0.3 m² of a surface obtained from a conditioning, and
converting the surface film into one of the functional layer which includes evaporation of the solvent deposited from the print head of the printer in said depositing,
wherein the conditioning includes at least one operation selected from cleaning, annealing, a plasma treatment, a flame treatment or a corona treatment, and vacuum-annealing at a temperature between 90°C and 180°C for 5 to 45 minutes, and
wherein the precursor comprises lead salts with iodine ions and acetate ions,
**characterized in that**
the solvent contains an ether, and
a viscosity of the solution is between 2.5 mPa·s and 5.5 mPa·s.

9. A method of producing a product which is a perovskite solar cell including a substrate a surface of which is provided with electrode wiring and further in the stated order with a stack of functional layers being, an electron transport layer on the substrate side, a perovskite layer, and a hole transport layer, the method comprising - repeatedly and for forming each of the functional layers - performing the method of claim 8 with the conditioning as and additional operation prior to the depositing.
